Europäisches Patentamt

European Patent Office

Office européen des brevets

(19)

(11) EP 0 783 798 B1

(12) **EUROPÄISCHE PATENTSCHRIFT**

(45) Veröffentlichungstag und Bekanntmachung des Hinweises auf die Patenterteilung:
**16.12.1998 Patentblatt 1998/51**

(21) Anmeldenummer: 95932768.5

(22) Anmeldetag: **18.09.1995**

(51) Int Cl.6: **H03K 5/08**, G01P 3/48

(86) Internationale Anmeldenummer:
**PCT/EP95/03655**

(87) Internationale Veröffentlichungsnummer:
**WO 96/09691 (28.03.1996 Gazette 1996/14)**

(54) **SCHALTUNGSANORDNUNG ZUR AUSWERTUNG DES AUSGANGSSIGNALS EINES AKTIVEN SENSORS**

CIRCUIT ARRANGEMENT FOR EVALUTATING THE OUTPUT SIGNAL FROM AN ACTIVE SENSOR

CIRCUIT D'EVALUATION DU SIGNAL DE SORTIE D'UN DETECTEUR ACTIF

(84) Benannte Vertragsstaaten:
**DE FR GB**

(30) Priorität: **24.09.1994 DE 4434180**

(43) Veröffentlichungstag der Anmeldung:
**16.07.1997 Patentblatt 1997/29**

(73) Patentinhaber: **ITT Automotive Europe GmbH 60488 Frankfurt (DE)**

(72) Erfinder:
- **ZINKE, Olaf**
  **D-65719 Hofheim (DE)**
- **FEY, Wolfgang**
  **D-65527 Niedernhausen (DE)**
- **ZYDEK, Michael**
  **D-35428 Langgöns (DE)**

(74) Vertreter: **Blum, Klaus-Dieter, Dipl.-Ing.
c/o ITT Automotive Europe GmbH
Guerickestrasse 7
60486 Frankfurt (DE)**

(56) Entgegenhaltungen:
**WO-A-94/06030         FR-A- 2 484 737
FR-A- 2 559 618**

- **PATENT ABSTRACTS OF JAPAN vol. 007 no. 132 (E-180) ,9.Juni 1983 & JP,A,58 047324 (FUJITSU KK) 19.März 1983,**
- **PATENT ABSTRACTS OF JAPAN vol. 012 no. 232 (E-628) ,30.Juni 1988 & JP,A,63 023413 (NEC CORP) 30.Januar 1988,**

## Beschreibung

Die Erfindung bezieht sich auf eine Schaltungsanordnung zur Auswertung des Ausgangssignals eines aktiven Sensors, das in Form eines binären Stromsignals, d.h. eines Rechtecksignals mit zwei unterschiedlichen Strompegeln, vorliegt, wobei die Schaltungsanordnung eine Kippschaltung mit einer veränderlichen Hysterese umfaßt.

Aus der DE 39 36 831 A1 ist bereits eine Schaltungsanordnung zur Aufbereitung des Ausgangssignals eines Drehzahlsensors bekannt, die eine Triggerschaltung oder Kippschaltung enthält, deren Umschaltschwellen in Abhängigkeit von einem Kopplungsfaktor, der die Sensor-Ausgangsspannung beeinflußt, variiert werden. Eine solche Schaltungsanordnung ist für passive und aktive Sensoren brauchbar. Bei Auswertung des Ausgangssignals eines aktiven Sensors, der ein binäres Stromsignal liefert, wäre jedoch eine Strom-/Spannungswandlung mit Hilfe eines in Serie geschalteten Lastwiderstandes notwendig, der relativ niederohmig sein müßte, damit an dem aktiven Sensor eine ausreichende Betriebsspannung anliegt. Dieser Widerstand müßte hochbelastbar sein, damit er auch einem Kurzschluß der Sensorleitung gegenüber der Versorgungsspannung widersteht. Außerdem wäre eine hohe Genauigkeit des Widerstandes erforderlich, weil von dieser die Sensorsignalerkennung abhängt. Solche Widerstände sind aufwendig, der hohe Energieverbrauch ist von Nachteil. Sensorfehler ließen sich nur mit zusätzlichem Schaltungsaufwand erkennen. Eine Überlappung von Funktionsbereich und Fehlererkennungsbereich ist mit einer solchen Schaltung bei Einsatz eines aktiven Sensors nicht möglich.

In der FR-A-2 559 618 ist ein integrierter Schaltkreis mit mehreren Stromspiegelschaltungen beschrieben, der in der Fernmeldetechnik eingesetzt werden soll. Durch mehrfache Stromspiegelung und durch Verwendung eines Differenzverstärkers wird ein dem Eingangsstrom umgekehrt proportionaler Ausgangsstrom erzeugt. Der Differenzverstärker wird mit eingeprägtem Strom betrieben und vergleicht eine vom dem Eingangsstrom abgeleitete Spannung mit einer Referenzspannung.

Der Erfindung liegt nun die Aufgabe zugrunde, eine Schaltungsanordnung zu entwickeln, die für aktive Sensoren, welche ein binäres Stromsignal liefern, geeignet ist. Es sollte auch bei ungünstigen Spannungs- und Bauelementetoleranzen eine sichere Erkennung des Ausgangssignals des aktiven, ein binäres Stromsignal liefernden Sensors gewährleistet sein. Außerdem sollten die in der Praxis unvermeidlichen Leckströme oder Nebenschlüsse, solange sie ein bestimmtes Maß nicht überschreiten, die Auswertung des Sensorsignals nicht beeinträchtigen. Andererseits sollten jedoch Kurzschlüsse der Sensorleitungen gegen Masse oder gegenüber der Stromzuführung, Kurzschlüsse der Sensorleitungen untereinander und Unterbrechungen der Sensorleitungen erkennbar sein. Schließlich sollte sich die Schaltungsanordnung zur Realisierung in Form einer integrierten Schaltung besonders gut eignen.

Es hat sich herausgestellt, daß diese Aufgabe mit der in Anspruch 1 beschriebenen Schaltungsanordnung zu lösen ist. Danach besteht das Besondere der erfindungsgmäßen. Schaltungsanordnung darin,

daß aus dem Sensorstrom mit Hilfe einer Stromspiegelschaltung zum Sensorstrom proportionale Signalströme gewonnen werden, daß einer der durch Stromspiegelung hervorgerufene Ströme einer Spannungsquelle über einen ohmschen Widerstand entnommen wird und dabei in ein dem Sensor-Ausgangssignal entsprechendes binäres Spannungssignal umgewandelt wird und daß dieses Spannungssignal der Kippschaltung mit veränderlicher Hysterese zugeführt wird, die das Spannungssignal mit einer Bezugsspannung, die sich aus einer Referenzspannung und einer Hysteresespannung zusammensetzt, vergleicht, und daß dei Umschaltschwelle der Kippschaltung von der Bezugsspannung abhängig ist.

Eine Stromspiegelung der erfindungsgemäß vorgesehenen Art läßt sich mit einer integrierten Schaltung auf einfache Weise verwirklichen. Der relativ hohe Sensorstrom wird mit Hilfe des Stromspiegels in einen kleineren, mit geringem Leistungsbedarf auswertbaren Strom transformiert. Dieser Strom wird über einen ohmschen Widerstand einer stabilisierten Spannungsquelle entnommen, um ein mit Hilfe einer Kippschaltung auswertbares, den Verlauf des Sensorsignals wiedergebendes Spannungssignal zu erzeugen.

Nach einem vorteilhaften Ausführungsbeispiel der Erfindung wird die Referenzspannung in Abhängigkeit von dem tatsächlichen, von Leckströmen, Nebenschlüssen, von der Höhe der Versorgungsspannung etc. beeinflußten Sensorstrom bzw. von dem transformierten, durch Stromspiegelung abgeleiteten Strom variiert und dadurch die Umschaltschwelle der Kippschaltung dem Sensorstrom nachgeführt. Auf diese Weise wird auch bei ungünstigen Toleranzen, bei der Überlagerung von Leckströmen oder bei der Reduzierung des Sensorstromes infolge von Nebenschlüssen eine sichere Erkennung und Auswertung des Sensorsignals ermöglicht.

In den abhängigen Patentansprüchen sind noch andere besonders vorteilhafte Ausführungsbeispiele der Erfindung beschrieben.

Weitere Einzelheiten der Erfindung gehen aus der folgenden Beschreibung von Ausführungsbeispielen anhand der beigefügten Abbildungen hervor.

Es zeigen

Fig. 1        in schematisch vereinfachter Teildarstellung ein Ausführungsbeispiel einer Schaltungsanordnung nach der Erfindung,

Fig. 2 bis 4      in gleicher Darstellungweise und mit weiteren Details Varianten der Schaltungsanordnung nach Fig. 1, und

Fig. 5A, 5B      eine weitere Variante der erfindungsgemäßen Schaltungsanordnung mit einem Fensterkomparator (Fig. 5B).

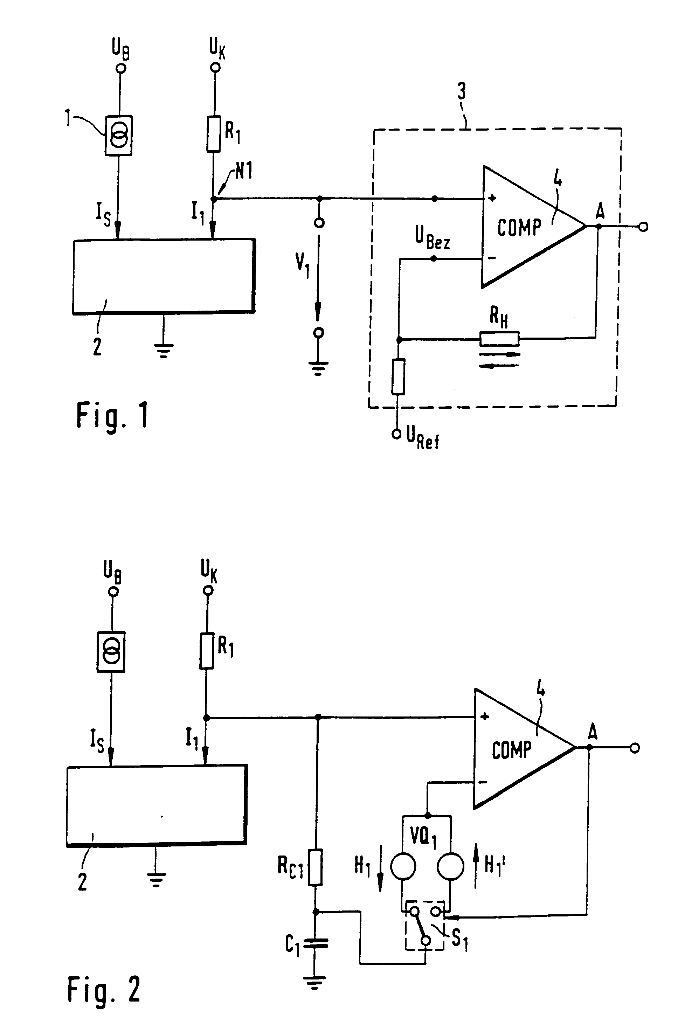

Zur Veranschaulichung des Aufbaus und der Arbeitsweise der erfindungsgemäßen Schaltungsanordnung dient Fig. 1. Ein aktiver Sensor 1, bei dem es sich z.B. um einen Radgeschwindigkeitssensor eines Antiblockiersystems für Kraftfahrzeuge handeln kann, liefert ein binäres Stromsignal $I_S$, d.h. ein Rechtecksignal mit zwei unterschiedlichen Strompegeln. Die Frequenz des Rechtecksignals ist der sensierten Geschwindigkeit des Rades proportional. Der aktive Sensor 1 ist einerseits an die Versorgungsspannung, hier an die Batterie des Fahrzeugs mit der Spannung $U_B$, und andererseits über eine Stromspiegelschaltung 2 an Masse angeschlossen. Der von dem Sensor 1 gelieferte Strom $I_S$ nimmt beispielsweise die Werte 7 mA (L) und 14 mA (H) an. Der Spannungsabfall über dem aktiven Sensor 1 darf einen Mindestwert von z.B. 8 Volt nicht unterschreiten, damit der Sensor in Funktion bleibt. Der Eingang der Stromspiegelschaltung 2, an den der Sensor 1 angeschlossen ist, muß folglich relativ niederohmig sein.

Die Batteriespannung $U_B$ bzw. die mit einer Batterie gepufferte Generatorspannung eines Kraftfahrzeugs schwankt bekanntlich bei einem Nennwert von 12 Volt zwischen etwa 9 und 18 Volt. Die beiden Pegel des Sensorsignals $I_S$, deren Nennwert 7 mA (L) und 14 mA (H) betragen soll, werden ebenfalls in Abhängigkeit von der tatsächlichen Batteriespannung, von den Toleranzen der einzelnen Bauteile, der Temperatur usw. zu höheren oder niedrigeren Werten verschoben.

Mit Hilfe der Stromspiegelschaltung 2 wird der Sensorstrom $I_S$ in einen sehr viel kleineren, proportionalen Signalstrom $I_1$ transformiert. Dieser Strom $I_1$ wird einer Quelle mit der stabilisierten Spannung $U_K$ über einen ohmschen Widerstand $R_1$ entnommen. Für das Spannungspotential $V_1$ am Knotenpunkt N1 gilt folglich die Bezeichnung

$$V_1 = U_K - R_1 \cdot I_1$$

Das Spannungspotential $V_1$ entspricht also dem Strom $I_1$ und damit dem Sensorstrom $I_S$.

Das Spannungssignal $V_1$ wird nun mit Hilfe einer Kippschaltung 3 ausgewertet, die einen Komparator 4 enthält, der das Spannungssignal $V_1$ mit einer Bezugsspannung $U_{Bez}$ vergleicht. Am Ausgang A der Kippschaltung 3 bzw. des Komparators 4 steht schließlich ein Rechtecksignal zur Verfügung, das in Abhängigkeit von dem Sensorstrom $I_S$ einen hohen (H) oder niedrigen (L) Wert annimmt. Die Umschaltung der Kippschaltung 3 bzw. des Komparators 4 setzt jeweils die Überwindung einer Hysteresespannung $\pm U_{Hyst}$ voraus, die in Fig. 1 als Spannungsabfall über einem Rückkopplungswiderstand $R_H$ symbolisch dargestellt ist. Die Erzeugung der Bezugsspannung $U_{Bez}$, die sich aus einer Referenzspannung $U_{Ref}$ und einer von der Hysteresespannung abhängigen Anteil zusammensetzt, wird im folgenden anhand der Figuren 2 bis 4 beschrieben.

Ein wesentliches Merkmal der Erfindung ist das Variieren der Umschaltschwelle des Komparators 4. Auf diese Weise wird eine Nachführung der Schaltschwellen an den tatsächlichen, von der Betriebsspannung, von Fertigungstoleranzen usw. abhängigen Sensorstrom $I_S$ erreicht. Die Unterscheidung zwischen einem hohen Signalpegel (H) bzw. Sensorstrom und einem niedrigen Signalpegel (L) oder Sensorstrom wird mit der erfindungsgemäßen Schaltungsanordnung infolge der Nachführung der Schaltschwellen auch dann noch möglich, wenn durch Leckströme oder Nebenschlüsse der Mittelwert des rechteckförmigen Sensorsignals verschoben ist.

Nach Fig. 2 wird die Nachführung der Schaltschwelle des Komparators 4 an den Sensorstrom $I_S$ bzw. an den gespiegelten Strom $I_1$ mit Hilfe eines Kondensators C1 erreicht, der über einen ohmschen Widerstand $R_{C1}$ auf das am Knoten N1 bzw. am Meßeingang des Komparators 4 herrschende Potential $V_1$ aufgeladen wird. C1 und $R_{C1}$ sind so aufeinander abgestimmt, daß die Kondensatorspannung $U_{C1}$ auch dann noch dem Signalwechsel von H nach L und umgekehrt folgen kann, wenn die Frequenz dieses Rechtecksignals (bei hoher Radgeschwindigkeit) hoch ist. Andererseits soll sich die Kondensatorspannung während der Flankendauer, d.h. während des Wechsels von H nach L bzw. L nach H höchstens geringfügig ändern.

Die Umschalthysterese wird in dem Ausführungsbeispiel nach Fig. 2 mit Hilfe einer Konstantspannungsquelle $VQ_1$, die die Hysteresespannung $H_1, H'_1$ liefert, hervorgerufen. Durch einen Umschalter S1, dessen Schaltstellung von dem Logikpegel H oder L am Ausgang des Komparators 4 abhängig ist, wird die Konstantspannungsquelle $VQ_1$ mit wechselnder Polarität $H_1, H'_1$ zwischen die Referenzspannung oder Kondensatorspannung $U_{C1}$ und dem N-Komparatoreingang eingefügt, so daß die Bezugsspannung am N-Eingang des Komparators 4 aus der Referenzspannung $U_{C1}$ zuzüglich oder abzüglich der Konstantspannung $H_1, H'_1$, die der Hysteresespannung entspricht, besteht. Bei Verwirklichung der Kippschaltung nach Fig. 2 mit Hilfe einer integrierten Schaltung lassen sich solche Konstantspannungsquellen $VQ_1$ wechselnder Polarität $H_1, H_1$ auf verschiedene Weise realisieren.

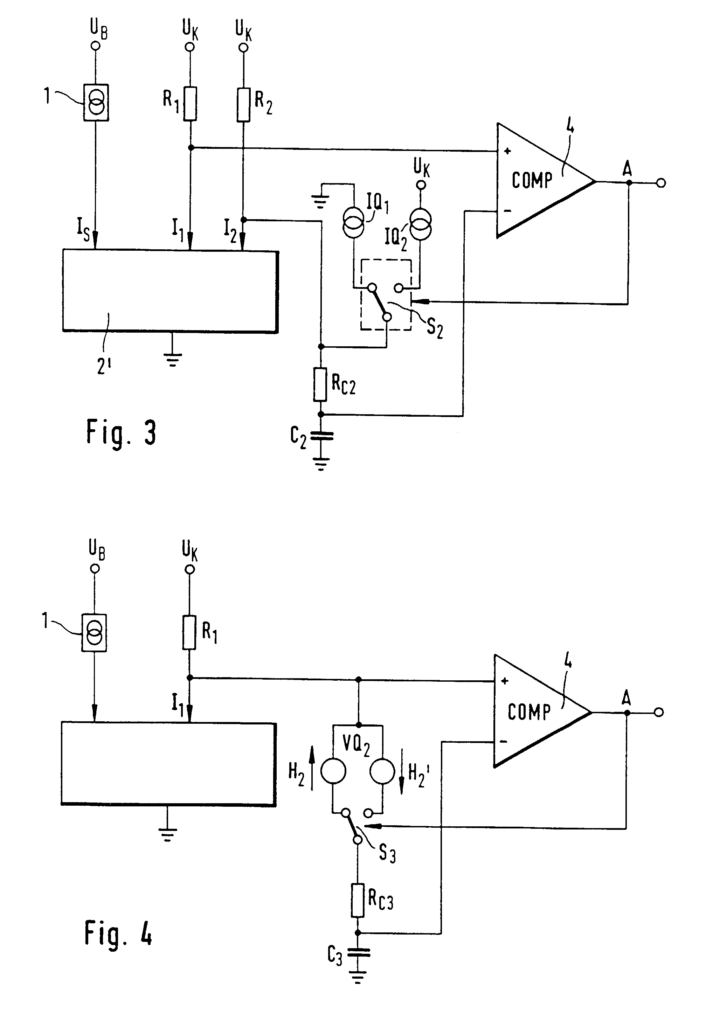

Die Schaltung nach Fig. 3 unterscheidet sich von dem Ausführungsbeispiel nach Fig. 2 dadurch, daß die Referenzspannung $U_{Ref}$ bzw. $U_{C2}$ mit Hilfe eines weiteren Schaltungszweigs, der ebenfalls einen dem Sensorstrom $I_S$ proportionalen, gespiegelten Strom $I_2$ führt, er-

zeugt wird. Da auch dieser Schaltungszweig an die Konstantspannungsquelle $U_K$ angeschlossen ist, wird $I_1 = I_2$, wenn die Widerstände $R_1, R_2$, über die die Ströme $I_1$, $I_2$ der Konstantspannungsquelle $U_K$ entnommen werden, gleich sind.

Nach Fig. 3 wird im Unterschied zu Fig. 2 die Hysteresespannung, deren Polarität sich bei jedem Umschalten des Komparators 4 ändern muß, mit Hilfe von Konstantstromquellen $IQ_1, IQ_2$ gewonnen, die über einen Umschalter $S_2$, dessen Schaltposition von dem Pegel H oder L am Ausgang A des Komparators 4 abhängt, einen zusätzlichen Ladestrom für den Kondensator $C_2$ liefern. Am N-Eingang des Komparators 4 steht wiederum eine Bezugsspannung an, die sich aus einem von dem Sensorstrom $I_S$ bzw. dem gespiegelten Strom $I_2$ abhängigen Anteil und aus einem die Hysteresespannung darstellenden, mit Hilfe der Stromquellen $I_{Q1}, I_{Q2}$ erzeugten Bestandteil zusammensetzt.

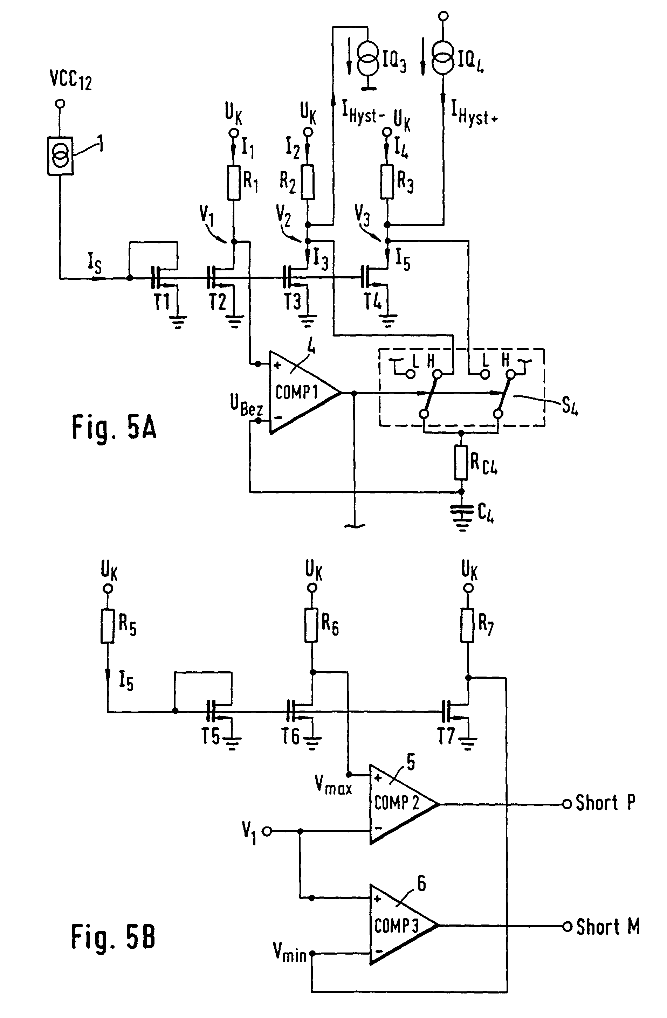

Nach Fig. 4 wird ebenfalls eine Spannungsquelle $VQ_2$ wechselnder Polarität über einen Umschalter $S_3$ in den vom Signaleingang oder P-Eingang des Komparators 4 zu einem Kondensator $C_3$ führenden Weg eingefügt, um die Spannung über dem Kodensator $C_3$ aus einer dem gespiegelten Sensorstrom $I_1$ proportionalen Komponente und einer die erforderliche Hysteresespannung $H_2, H'_2$, berücksichtigenden Komponente zusammenzusetzen. Außer den Varianten 2 und 4 gibt es noch andere, prinzipiell gleichwertige Möglichkeiten zur Erzeugung einer nachgeführten, die jeweilige Batteriespannung $U_B$ und die Toleranzen berücksichtigenden und außerdem eine Schalthysterese hervorrufenden Bezugsspannung $U_{Bez}$. Der Kondensator und der für die Lade-/Entladezeiten des Kondensators maßgebende Widerstand ist in jedem Fall so zu bemessen, daß sich die Kondensatorspannung während der Signalflanken nur unwesentlich ändert, daß jedoch während der wechselnden Signalzustände (H/L, L/H) eine Umladung stattfinden kann.

In Fig. 5A sind weitere Details einer Schaltungsanordnung der erfindungsgemäßen Art wiedergegeben. Die Stromspiegelung wird mit Hilfe von Transistoren T1 bis T4, die einem gemeinsamen integrierten Schaltkreis angehören, verwirklicht. T1 ist die Eingangsstufe der Stromspiegelschaltung, der der Sensorstrom $I_S$ des aktiven Sensors 1 zugeführt wird. Der Sensorstrom $I_S$ wird in den Transistorstufen T2, T3, T4 gespiegelt. Die Erzeugung eines dem Sensorstrom $I_S$ entsprechenden Spannungssignals $V_1$ und dessen Auswertung mit Hilfe des Komparators 4 gleicht dem Ausführungsbeispiel nach Fig. 3. Für übereinstimmende Teile wurden daher gleiche Bezugsziffern und Bezeichnungen gewählt.

Die Umschalthysterese und Referenzspannung werden nach Fig. 5A mit Hilfe der Transistoren T3, T4, die ebenfalls den Sensorstrom $I_S$ spiegeln, mit Hilfe der Konstantstromquellen $IQ_3, IQ_4$ und eines Umschalters $S_4$, der ebenfalls durch Schalttransistoren des gemeinsamen integrierten Schaltkreises verwirklicht ist, realisiert. Die Bezugsspannung $U_{Bez}$ für das Spannungssignal am N-Eingang des Komparators 4 wird wiederum mit Hilfe eines Kondensators $C_4$, der über einen Widerstand $R_{C4}$ geladen wird, erzeugt.

Der Sensorstrom $I_S$ wird also in dem Stromspiegel T1, T2 in der bereits erläuterten Weise umgesetzt. Für $I_1$ gilt, wenn mit $A_1, A_2$ die Flächen der Transistoren T1, T2 des integrierten Schaltkreises bezeichnet werden, die Beziehung

$$I_1 = A_2/A_1 \times I_S$$

Am Drain-Anschluß des Transistors T2 stellt sich deshalb ein Potential $V_1$ ein, das sich wie folgt berechnen läßt:

$$V_1 = U_k - R_1 I_1.$$

T3 und $R_2$ werden zweckmäßigerweise derart bemessen, daß bei $I_{Hyst} = 0$ die Drain-Spannung am Transistor T3 mit der Drainspannung am Transistor T2 übereinstimmt. Unter Berücksichtigung des Stromes $I_{Hyst}$ stellt sich am Transistor T3 folgende Drain-Spannung ein:

$$V_2 = U_K - R_2(I_3 + I_{Hyst})$$

und damit

$$V_2 = U_K - R_2((A_3/A_1) I_S + I_{Hyst}).$$

Die Stromquelle $I_{Q3}$ und damit $I_{Hyst}$ werden so dimensioniert, daß sich eine Spannung $V_2$ einstellt, die der Spannung $V_1$ abzüglich einer Differenzspannung $\Delta V_1$ entspricht, wobei dieses $\Delta V_1$ der minimalen Stromdifferenz zwischen dem Sensorstrompegel H (High) und dem Sensorstrompegel L (Low) entspricht. Es gilt also

$$V_2 = V_1 - \Delta V_1$$

und

$$\Delta V_1 = R_1 (A_2/A_1) (I_{Hmin} - I_{Lmax})$$

Wenn mit Hilfe des Komparator 4 ein L-Strompegel erkannt worden ist, wird der Kondensator $C_4$ auf die zuvor abgeleitete Spannung $V_2$ aufgeladen. Steigt nun der Sensorstrom $I_S$, so schaltet der Komparator 4 um, sobald der Strom um einen der Schalthysterese entsprechenden Betrag $I_{Hmin} - I_{Lmax}$ angestiegen ist. Daraufhin wird der Kondensator $C_4$ auf die Spannung $V_3$ aufgeladen. Diese Spannung wird auf den Umschaltpunkt bzw. auf den Übergang von der High(H)- zur Low(L)-Strom-

flanke eingestellt; bei $R_2 = R_3$ und $A_3 = A_4$ ergibt sich

$$V_3 = V_1 + \Delta V_1 \ .$$

Sinkt der Sensorstrom ausgehend von dem Strom-H-Pegel um den der Schalthysterese $I_{Hmin} - I_{Lmax}$ entsprechenden Betrag, erfolgt eine Zurückschaltung des Komparators 4.

Für die Dimensionierung des Kondensators $C_4$ und des Widerstandes $R_{C4}$ gilt wiederum, daß sich einerseits während der Schaltflanken die Kondensatorspannung kaum ändern darf, während die kürzeste Zeitspanne der Umschaltung von H auf L bzw. L auf H zur Änderung der Kondensatorspannung entsprechend der Signal-änderung $V_2$ bzw. $V_3$ ausreichen muß.

Die Stromquellen $I_{Q3}$ und $I_{Q4}$ können grundsätzlich durch Stromspiegelung von einer gemeinsamen Stromquelle abgeleitet werden. In Fig. 5A sind der Einfachheit halber zwei voneinander unabhängige Stromquellen dargestellt.

Durch das anhand der Figuren 1 bis 5 beschriebene Nachführen der Umschaltschwelle der Kippschaltung 3 bzw. des Komparators 4 wird ein Erkennen und Auswerten des Sensorsignals $I_S$ selbst dann noch möglich, wenn aufgrund von Leckströmen, Nebenschlüssen und dergl. der L-Strompegel des Sensorstroms $I_S$ größer wird als $I_{Lmax}$ oder der H-Strompegel kleiner wird als $I_{Hmin}$. Sensorsignal wird sogar dann erkannt, wenn L- und H- Pegel sich zwischen $I_{Hmin}$ und $I_{Hmax}$ oder zwischen $I_{Lmin}$ und $I_{Lmax}$ befinden. Selbst bei diesen Extrembedingungen bleibt die Schalthysterese von $I_{Hmin} - I_{Lmax}$ erhalten.

Übersteigen die Leckströme oder Nebenschlüsse ein bestimmtes Maß oder liegt ein Sensorfehler, Leitungsunterbrechung oder dergl. vor, wird mit Hilfe eines in Fig. 5B dargestellten Fensterkomparators, der sich auf demselben IC wie die Schaltung nach Fig. 5A befindet, der fehlerhafte Zustand signalisiert.

Die zulässigen Grenzen des Spannungssignals $V_1$ werden mit Hilfe einer Stromspiegelschaltung T5,T6,T7 definiert. Die obere Grenze wird durch den Strom $I_5$ bestimmt, der der stabilisierten Spannungsquelle $U_K$ über einen ohmschen Widerstand $R_5$ entnommen wird. Von T5 wird nach T6 ein Strom gespiegelt, der dem maximal zulässigen Strom entspricht. Gilt $R_6 = R_1$, stellt sich am Drain-Anschluß des Transistors T6 ein Spannungswert ein, der die obere Grenze $V_{max}$ wiedergibt. Überschreitet $V_1$ diesen Spannungswert $V_{max}$, wird dies als Sensorfehler gewertet. Ein Komparator 5 vergleicht $V_1$ mit dem Spannungspotential am Drain des Transistors T6. H am Ausgang "Short P" des Komparators 5 signalisiert einen Kurzschluß oder unzulässig hohen Nebenschluß zwischen dem Sensor 1 oder der Sensorleitung und der Versorgungsspannung $U_B$.

Der Sensorstrom $I_S$ sinkt unter seinen Minimalwert ab, wenn einer der Sensoranschlüsse gegen Masse kurzgeschlossen ist, wenn über einen Leckwiderstand Strom zur Masse hin abfließt oder wenn Sensorzuleitungen unterbrochen sind. Dies wird mit Hilfe der Schaltung nach Fig. 5B folgendermaßen erkannt: Von dem Transistor T5 wird über T7 ein Strom gespiegelt, der dem minimalen Sensorstrom entspricht. Gilt $R_7 = R_1$, stellt sich am Drain-Anschluß des Transistors T7 ein Spannungswert $V_{min}$ ein, bei dessen Unterschreiten ein Sensorfehler vorliegen muß. Ein Komparator 6 vergleicht $V_1$ mit dem Potential $V_{min}$ am Drain des Transistors T7. Ein H am Ausgang "Short M" des Komparators 6 signalisiert das Unterschreiten des vorgegebenen minimalen Sensorstroms.

Das Ausgangssignal des Komparators 5 (Short P) wird zweckmäßigerweise - was allerdings nicht dargestellt ist - zur Unterbrechung des Sensorstromes $I_S$ und damit zum Schutz des Eingangstransistors T1 vor Überlastung ausgewertet.

## Patentansprüche

1. Schaltungsanordnung zur Auswertung des Ausgangssignals eines aktiven Sensors, das in Form eines binären Stromsignals, d.h. eines Rechtecksignals mit zwei unterschiedlichen Strompegeln, vorliegt, wobei die Schaltungsanordnung eine Kippschaltung mit einer veränderlichen Hysterese umfaßt, dadurch **gekennzeichnet,**

   - daß aus dem Sensorstrom ($I_S$) mit Hilfe einer Stromspiegelschaltung (2,2') zum Sensorstrom ($I_S$) proportionale Signalströme ($I_1$, $I_2$, $I_4$) gewonnen werden,
   - daß einen der durch Stromspiegelung hervorgerufene Ströme ($I_1$) einer Spannungsquelle ($U_K$) über einen ohmschen Widerstand ($R_1$) entnommen wird und dabei in ein dem Sensor-Ausgangssignal entsprechendes binäres Spannungssignal ($V_1$) umgewandelt wird und
   - daß dieses Spannungssignal ($V_1$) der Kippschaltung (3) mit veränderlicher Hysterese zugeführt wird, die das Spannungssignal ($V_1$) mit einer Bezugsspannung ($U_{Bez}$), die sich aus einer Referenzspannung ($U_{Ref}$) und einer Hysteresespannung ($U_{Hyst}$) zusammensetzt, vergleicht,
   - wobei die Umschaltschwelle der Kippschaltung (3) von der Bezugsspannung ($U_{Bez}$) abhängig ist.

2. Schaltungsanordnung nach Anspruch 1, dadurch **gekennzeichnet**, daß die Referenzspannung ($U_{Ref}$) in Abhängigkeit von dem tatsächlichen, von Leckströmen, Nebenschlüssen, von der Versorgungsspannung etc. beeinflußten Sensorstrom ($I_S$) bzw. von dem durch Stromspiegelung gewonnenen Signalstrom ($I_1$) variiert wird und dadurch die Umschaltschwelle der Kippschaltung (3) dem Sensorstrom ($I_S$) nachgeführt wird.

3. Schaltungsanordnung nach Anspruch 2, dadurch **gekennzeichnet,** daß die Referenzspannung ($U_{Ref}$) mit Hilfe eines Kondensators (C1,C2,C3,C4) gewonnen wird, der über einen ohmschen Widerstand ($R_{C1}$ bis $R_{C4}$) an den Signaleingang der Kippschaltung, d.h. an den Eingang der Kippschaltung (3), an dem das Spannungssignal ($V_1$) anliegt, angeschlossen ist.

4. Schaltungsanordnung nach Anspruch 2, dadurch **gekennzeichnet**, daß die Referenzspannung ($V_{Ref}$) mit Hilfe eines Kondensators (C2) gewonnen wird, der über einen ohmschen Widerstand ($R_{C2}$) an einen weiteren Schaltungszweig der Stromspiegelschaltung(2'), der einen über einen ohmschen Widerstand ($R_3$), der Spannungsquelle ($U_K$) entnommenen, zum Sensorstrom ($I_S$) proportionalen Strom ($I_S$) führt, angeschlossen ist.

5. Schaltungsanordnung nach Anspruch 3 oder 4, dadurch **gekennzeichnet**, daß die Bezugsspannung ($U_{Bez}$) durch Hintereinanderschaltung der Referenzspannung ($U_{Ref}$) und einer die Hysteresespannung ($H_1,H'_1$) liefernden Konstantspannungsquelle ($VQ_1$), deren Polarität bei jedem Umschalten der Kippschaltung (3) wechselt, gebildet wird.

6. Schaltungsanordnung nach Anspruch 3 oder 4, dadurch **gekennzeichnet**, daß die Hysteresespannung mit Hilfe von Konstantstromquellen ($IQ_1,IQ_2$), die je nach Schaltzustand der Kippschaltung (3) die Kondensatorspannung bzw. Kondensatorladung erhöhen oder erniedrigen, hervorgerufen wird.

7. Schaltungsanordnung nach einem oder mehreren der Ansprüche 1 bis 6, dadurch **gekennzeichnet**, daß die Spannungsquelle ($U_K$), der die gespiegelten Ströme entnommen werden, stabilisiert ist.

8. Schaltungsanordnung nach einem oder mehreren der Ansprüche 1 bis 7, dadurch **gekennzeichnet**, daß ein Fensterkomparator vorhanden ist, der das dem Sensorausgangssignal ($I_S$) entsprechende binäre Spannungssignal ($V_1$) mit einem vorgegebenen oberen ($V_{max}$) und einem vorgegebenen unteren ($V_{min}$) Grenzwert vergleicht und beim Überschreiten bzw. Unterschreiten dieser Grenzwerte ($V_{max}, V_{min}$) ein Fehlersignal liefert.

9. Schaltungsanordnung nach einem oder mehreren der Ansprüche 2 bis 8, dadurch **gekennzeichnet**, daß die Zeitkonstante des RC-Gliedes, das den die Referenzspannung ($U_{Ref}$) hervorrufenden Kondensator (C1 bis C4) enthält, derart bemessen ist, daß einerseits die Kondensatorspannung ($U_{C1}$ bis $U_{C4}$) dem binären Spannungssignal ($V_1$) folgt, daß andererseits während der Umschaltzeit des Spannungssignals die Änderung der Kondensatorspannung nur gering ist.

## Claims

1. Circuit arrangement for evaluating the output signal of an active sensor which is configured as a binary current signal, i.e., a square-wave signal with two different current levels, the circuit arrangement including a flipflop with a variable hysteresis, **characterized** in that

   - signal currents ($I_1$, $I_2$, $I_4$) proportional to the sensor current (Is) are produced from the sensor current (Is) by way of a current mirror circuit (2, 2'),
   - one of the currents ($I_1$) induced by a current mirroring operation is drawn from a voltage source ($U_K$) by way of an ohmic resistance ($R_1$) and is converted into a binary voltage signal ($V_1$) corresponding to the sensor output signal,
   - this voltage signal ($V_1$) is sent to the flipflop (3) which has a variable hysteresis and compares the voltage signal ($V_1$) with a reference value ($U_{Bez}$) that is composed of a reference voltage ($U_{Ref}$) and a hysteresis voltage ($U_{Hyst}$),
   - wherein the change-over threshold of the flipflop (3) is responsive to the reference value ($U_{Bez}$).

2. Circuit arrangement as claimed in claim 1, **characterized** in that the reference voltage ($U_{Ref}$) is varied as a function of the actual sensor current ($I_S$), which is influenced by leakage currents, shunts, the supply voltage, etc., or as a function of the signal current ($I_1$) produced by a current mirroring operation, and the change-over threshold of the flipflop (3) is thereby adapted to the sensor current ($I_S$).

3. Circuit arrangement as claimed in claim 2, **characterized** in that the reference voltage ($U_{Ref}$) is produced by way of a capacitor (C1, C2, C3, C4) which is connected to the signal input of the flipflop, i.e. to the input of the flipflop (3) to which the voltage signal ($V_1$) is applied, by way of an ohmic resistance ($R_{C1}$ to $R_{C4}$).

4. Circuit arrangement as claimed in claim 2, **characterized** in that the reference voltage ($U_{Ref}$) is produced by way of a capacitor (C2) which is connected to another circuit branch of the current mirror circuit (2') by way of an ohmic resistance ($R_{C2}$), the circuit branch conducting a current (Is) which is drawn from the voltage source ($U_K$) by way of an ohmic resistance ($R_3$) and is proportional to the sensor current ($I_S$).

5. Circuit arrangement as claimed in claim 3 or 4, **characterized** in that the reference value ($U_{Bez}$) is provided by series connection of the reference voltage ($U_{Ref}$) and a constant voltage source ($VQ_1$) which furnishes the hysteresis voltage ($H_1$, $H'_1$) and has a polarity alternating with each change-over of the flipflop (3).

6. Circuit arrangement as claimed in claim 3 or 4, **characterized** in that the hysteresis voltage is produced by constant current sources ($IQ_1$, $IQ_2$) which increase or decrease the capacitor voltage or capacitor charging responsive to the switch condition of the flipflop (3).

7. Circuit arrangement as claimed in any one or more of claims 1 to 6, **characterized** in that the voltage source ($U_K$), from which the mirrored currents are drawn, is stabilized.

8. Circuit arrangement as claimed in any one or more of claims 1 to 7, **characterized** in that a window comparator compares the binary voltage signal ($V_1$) which corresponds to the sensor output signal ($I_S$) with a predetermined top limit value ($V_{max}$) and a predetermined bottom limit value ($V_{min}$) and issues an error signal when the limit values ($V_{max}$, $V_{min}$) are exceeded or fall short of.

9. Circuit arrangement as claimed in any one or more of claims 2 to 8, **characterized** in that the time constant of the RC-element, which includes the capacitor (C1 to C4) inducing the reference voltage ($U_{Ref}$), is rated so that the capacitor voltage ($U_{C1}$ to $U_{C4}$) follows the binary voltage signal ($V_1$), on the one hand, and that there is only a slight variation of the capacitor voltage during the change-over time of the voltage signal, on the other hand.

**Revendications**

1. Agencement de circuit permettant d'exploiter le signal de sortie d'un capteur actif qui se présente sous la forme d'un signal de courant binaire, c'est-à-dire d'un signal rectangulaire comportant deux niveaux de courant différents, l'agencement de circuit comprenant une bascule à hystérésis variable, caractérisé

- en ce que des courants de signal ($I_1$, $I_2$, $I_4$) proportionnels au courant de capteur ($I_S$) sont obtenus à partir du courant de capteur ($I_S$) au moyen d'un circuit de miroir de courant (2, 2'),

- en ce que l'un des courants ($I_1$) créé par la formation de miroir de courant est prélevé sur une source de tension ($U_K$) à travers une résistance ohmique ($R_1$) et est alors converti en un signal binaire de tension ($V_1$) correspondant au signal de sortie de capteur et

- en ce que ce signal de tension ($V_1$) est envoyé à la bascule (3) à hystérésis variable qui compare le signal de tension ($V_1$) à une tension de base ($U_{base}$) qui se compose d'une tension de référence ($U_{réf}$) et d'une tension d'hystérésis ($U_{hyst}$),

- le seuil de commutation de la bascule (3) dépendant de la tension de référence de base ($U_{base}$).

2. Agencement de circuit suivant la revendication 1, caractérisé en ce que la tension de référence ($U_{réf}$) est modifiée en fonction du courant de capteur ($I_S$) effectif, subissant l'influence de fuites de courant, de dérivations, de la tension d'alimentation, etc., ou en fonction du courant de signal ($I_1$) obtenu au moyen de la formation d'image de courant et, de ce fait, le seuil de commutation de la bascule (3) suit le courant de capteur ($I_S$).

3. Agencement de circuit suivant la revendication 2, caractérisé en ce que la tension de référence ($U_{réf}$) est obtenue au moyen d'un condensateur ($C_1$, $C_2$, $C_3$, $C_4$) qui est connecté, à travers une résistance ohmique ($R_{C1}$ à $R_{C4}$) à l'entrée de signal de la bascule, c'est-à-dire à l'entrée de la bascule (3) sur laquelle le signal de tension ($V_1$) est appliqué.

4. Agencement de circuit suivant la revendication 2, caractérisé en ce que la tension de référence ($V_{réf}$) est obtenue au moyen d'un condensateur ($C_2$) qui est connecté à travers une résistance ohmique ($R_{C2}$) à une autre branche de circuit du circuit d'image de courant (2') qui fait passer un courant ($I_S$) prélevé à travers une résistance ohmique ($R_3$) sur la source de tension ($U_K$) et est proportionnel au courant de capteur ($I_S$).

5. Agencement de circuit suivant la revendication 3 ou 4, caractérisé en ce que la tension de base ($U_{base}$) est formée par mise en circuit l'une derrière l'autre de la tension de référence ($U_{réf}$) et d'une source de tension constante ($VQ_1$) qui délivre la tension d'hystérésis ($H_1$, $H'_1$) et dont la polarité alterne à chaque commutation de la bascule (3).

6. Agencement de circuit suivant la revendication 3 ou 4, caractérisé en ce que la tension d'hystérésis est créée au moyen de sources de courant constant ($IQ_1$, $IQ_2$) qui augmentent ou diminuent chacune la tension de condensateur ou la charge de condensateur en fonction de l'état de commutation de la bascule (3).

7. Agencement de circuit suivant une ou plusieurs des revendications 1 à 6, caractérisé en ce que la source de tension ($U_K$) sur laquelle sont prélevés les courants faisant l'objet d'une formation d'image est stabilisée.

8. Agencement de circuit suivant une ou plusieurs des revendications 1 à 7, caractérisé en ce qu'il est prévu un comparateur de fenêtre qui compare le signal binaire de tension ($V_1$) correspondant au signal de sortie de capteur ($I_S$) à une valeur limite supérieure préfixée ($V_{max}$) et à une valeur limite inférieure préfixée ($V_{min}$) et qui délivre un signal d'erreur lors du franchissement respectivement vers le haut et vers le bas de ces valeurs limites ($V_{max}$, $V_{min}$).

9. Agencement de circuit suivant une ou plusieurs des revendications 2 à 8, caractérisé en ce que la constante de temps du circuit RC qui contient le condensateur ($C_1$ à $C_4$) créant la tension de référence ($U_{réf}$) est dimensionnée de façon que, d'une part, la tension de condensateur ($U_{C1}$ à $U_{C4}$) suit le signal binaire de tension ($V_1$) et que, d'autre part, la variation de la tension de condensateur n'est que faible pendant le temps de commutation du signal de tension.

Fig. 1

Fig. 2

Fig. 3

Fig. 4

Fig. 5A

Fig. 5B